Europäisches Patentamt

European Patent Office

Office européen des brevets

(19)

(11) Veröffentlichungsnummer: **0 354 616**
**A2**

(12) **EUROPÄISCHE PATENTANMELDUNG**

(21) Anmeldenummer: 89202027.2

(51) Int. Cl.⁴ **C04B 35/00 , C04B 41/50 , B32B 18/00 , H01L 39/24**

(22) Anmeldetag: 03.08.89

(30) Priorität: 09.08.88 DE 3826924

(43) Veröffentlichungstag der Anmeldung:
14.02.90 Patentblatt 90/07

(84) Benannte Vertragsstaaten:
**DE FR GB**

(71) Anmelder: **Philips Patentverwaltung GmbH
Wendenstrasse 35 Postfach 10 51 49
D-2000 Hamburg 1(DE)**
(84) **DE**

Anmelder: **N.V. Philips' Gloeilampenfabrieken
Groenewoudseweg 1
NL-5621 BA Eindhoven(NL)**
(84) **FR GB**

(72) Erfinder: **Klee, Mareike Katharine, Dr.
Randeratherweg 27
D-5142 Hückelhoven/Brachelen(DE)**
Erfinder: **Stotz, Siegfried, Dr.
Mühlental 33
D-5100 Aachen(DE)**
Erfinder: **Brand, Wolfgang
Schlossparkstrasse 43
D-5100 Aachen(DE)**

(74) Vertreter: **Nehmzow-David, Fritzi-Maria et al
Philips Patentverwaltung GmbH
Wendenstrasse 35 Postfach 10 51 49
D-2000 Hamburg 1(DE)**

(54) **Verfahren zur Herstellung einer supraleitenden oxidischen Schicht.**

(57) Verfahren zur Herstellung einer supraleitenden oxidischen, mindestens eine Wismut-Cuprat-Verbindung enthaltenden Schicht auf einem Substrat, wobei eine homogene Lösung aus metallorganischen Verbindungen in Form von Carbonsäure-Verbindungen von Calcium, Strontium, Wismut und Kupfer in einem organischen Lösungsmittel auf dem Substrat abgeschieden wird, wonach die metallorganischen Verbindungen thermisch zersetzt werden und die Schicht anschließend bei einer Temperatur im Bereich von 700 bis 950 °C ausgeheizt wird, wobei Wismut in einer Menge im Bereich von 10 bis 40 Atom% durch Blei substituiert wird.

## Verfahren zur Herstellung einer supraleitenden oxidischen Schicht

Die Erfindung betrifft ein Verfahren zur Herstellung einer supraleitenden oxidischen, mindestens eine Wismut-Cuprat-Verbindung enthaltenden Schicht auf einem Substrat, wobei eine homogene Lösung aus metallorganischen Verbindungen in Form von Carbonsäure-Verbindungen von Calcium, Strontium, Wismut und Kupfer in einem organischen Lösungsmittel auf dem Substrat abgeschieden wird, wonach die metallorganischen Verbindungen thermisch zersetzt werden und die Schicht anschließend bei einer Temperatur im Bereich von 700 bis 950 °C ausgeheizt wird.

Ein derartiges Verfahren ist aus der deutschen Patentanmeldung P 38 15 460.9 bekannt.

Aus Messungen an Formkörpern ist bekannt, daß Wismut-Cuprat-Verbindungen mehrphasig sein können, wobei die unterschiedlichen Phasen unterschiedliche kritische Temperaturen aufweisen, z.B. 80 K und 105 K; hierzu wird verwiesen auf Jap.J. of Appl. Phys. Letters 27 (1988), L209.

Aus Phys. Letters A 128 (1988), 1-2, S. 102-104 ist ein Kathcdenzerstäubungsverfahren bekannt, mit dem eine Calcium/Strontium/Wismut-Cuprat-Schicht einer Dicke von 1 μm hergestellt und anschließend in Sauerstoff bei einer Temperatur von 880 bis 900 °C thermisch nachbehandelt wird.

Das aus dieser Vorveröffentlichung bekannte Dünnschichtverfahren liefert ein Material mit einer Widerstands-Temperatur-Kurve, die fast keinen Anteil an der Phase aufweist, die die höhere kritische Temperatur oberhalb von 100 K hat. Versuche, die zur vorliegenden Erfindung geführt haben, haben gezeigt, daß auch andere Verfahren zum Abscheiden derartiger dünner Schichten, wie ein Laserabscheideverfahren, aber auch eine thermische Nachbehandlung der nach dem bekannten Verfahren hergestellten dünnen Schichten diese Sachlage nicht verbessern.

Der Erfindung liegt die Aufgabe zugrunde, das eingangs genannte Verfahren derart zu verbessern, daß eine Schicht erhalten wird, die Supraleitung zeigt bei einer Temperatur oberhalb 100 K.

Diese Aufgabe wird erfindungsgemäß dadurch gelöst, daß Wismut in einer Menge im Bereich von 10 bis 40 Atom% durch Blei substituiert wird.

Überraschenderweise hat sich gezeigt, daß gerade die für die Supraleitfähigkeit der Schichten erwünschte Phase mit der hohen kritischen Temperatur von > 100 K als überwiegender Schichtbestandteil erreicht werden kann, wenn Wismut in einem Bereich von 10 bis 40 Mol% durch Blei substituiert wird.

Die Schichten sind relativ grob kristallin mit Kristallitgrößen bis zu 10 μm und zeigen ausgeprägte polykristalline Textur, wobei die überwiegende Phase der Schichten in pseudotetragonaler Symmetrie mit einer c-Achse von 3,707 nm kristallisiert. Die nach dem vorliegenden Verfahren hergestellten Schichten weisen vollständige Supraleitfähigkeit oberhalb 100 K auf.

Nach einer vorteilhaften Ausgestaltung des Verfahrens gemäß der vorliegenden Erfindung wird Wismut in einer Menge von 20 Atom% durch Blei substituiert.

Nach einer weiteren vorteilhaften Ausgestaltung des erfindungsgemäßen Verfahrens werden die metallorganischen Verbindungen bei einer Temperatur im Bereich von 300 bis 600 °C thermisch zersetzt.

Nach einer weiteren vorteilhaften Ausgestaltung des erfindungsgemäßen Verfahrens werden der Abscheidungsprozeß, der Zersetzungsprozeß und der Ausheizprozeß wiederholt, bis eine gewünschte Schichtdicke erreicht ist.

Nach einer vorteilhaften Weiterbildung des Verfahrens gemäß der Erfindung werden die auf dem Substrat abgeschiedenen und anschließend thermisch zersetzten metallorganischen Verbindungen über eine Dauer von 1 bis 60 h ausgeheizt.

Nach einer weiteren vorteilhaften Ausgestaltung des erfindungsgemäßen Verfahrens werden die auf dem Substrat abgeschiedenen und anschließend thermisch zersetzten metallorganischen Verbindungen bei einer Temperatur im Bereich von 850 bis 878 °C ausgeheizt.

Mit dem vorliegenden Verfahren ist der Vorteil verbunden, daß ein Verfahren geschaffen ist, mit dem auf einfache und billige Weise auch Schichten oder Schichtenfolgen hergestellt werden können, die eine größere Dicke, z.B. größer als 10 μm, haben und welches infolge kurzer Reaktionszeiten zeitsparend und damit kostengünstig ist.

Ein weiterer Vorteil des vorliegenden Verfahrens ist, daß die Prozeßparameter wie Stöchiometrie der abgeschiedenen Schicht oder die Temperaturführung der thermischen Zersetzung und des Ausheizens der abgeschiedenen Schicht genau gesteuert werden können.

Zum Abscheiden der homogenen Lösung auf dem Substrat können sämtliche an sich bekannte Verfahren angewendet werden, wie z.B. Schleudern, Tauchen oder Sprühen.

Als Substratmaterialien sind insbesondere geeignet Magnesiumoxid in polykristalliner oder einkristalliner Form, Strontiumtitanat, Aluminiumoxid oder Zirkonoxid.

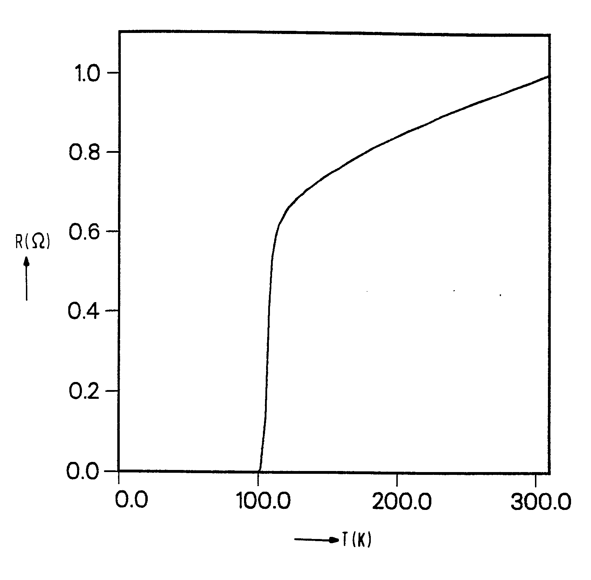

Die Erfindung wird anhand eines Ausführungsbeispiels und einer Zeichnung erläutert. In der Zeichnung zeigt die einzige Figur ein Diagramm, in dem der elektrische Widerstand R als Funktion der absoluten Temperatur T dargestellt ist, gemessen an einer nach dem erfindungsgemäßen Verfahren hergestellten Schicht.

Ausführungsbeispiel.

Für die Herstellung der homogenen Lösung zur Abscheidung der Schicht werden Calciumnaphthenat, Strontiumoktoat, Wismutoktoat, Blei-2-ehtylhexanoat und Kupfer-2-ehtylhexanoat, gelöst in Kohlenwasserstoffen mit einem Siedepunkt von 160 bis 190 °C, verwendet, wobei der Gewichtsanteil der Metalle in den Lösungen für Ca 10 Gew.%, für Sr 8 Gew.%, für Bi 20 Gew.%, für Pb 25 Gew.% und für Cu 11,5 Gew.% beträgt.

Diese Verbindungen werden im molaren Verhältnis Ca:Sr:Bi:Pb:Cu = 1:0,8:0,8:0,2:1,6 zusammengefügt. Die Lösung, die 0,0127 Mol Cu enthält, wird mit 3,3 ml Chloroform verdünnt. Diese Lösung wird durch einen Tauchprozeß auf MgO-Substraten abgeschieden. Die auf diese Weise erhaltenen Schichten werden bei einer Temperatur im Bereich von 120 bis 150 °C innerhalb von 30 min getrocknet. Die metallorganischen Verbindungen werden anschließend bei einer Temperatur von 500 °C über eine Dauer von 30 min thermisch zersetzt.

Nach viermaligem Beschichten und thermischem Zersetzen erfolgt ein Ausheizen der Schichtenfolge bei einer Temperatur von 860 °C. Dazu werden die Schichten mit vorzugsweise einer Aufheizgeschwindigkeit von 430 °C/h auf eine Temperatur von 860 °C aufgeheizt, eine Stunde an Luft auf dieser Temperatur gehalten, mit einer Abkühlgeschwindigkeit von 210 °C/h auf eine Temperatur von 650 °C abgekühlt und bei dieser Temperatur 1 Stunde nachbehandelt. Anschließend werden die Schichten innerhalb einer Dauer von 3 Stunden auf Raumtemperatur abgekühlt.

Der gesamte Prozeß kann wiederholt werden, bis eine gewünschte Schichtdicke erreicht ist.

Aus dem Diagramm gemäß der Figur ist ersichtlich, daß die nach dem vorliegenden Verfahren hergestellte Schicht ein Einsetzen der Supraleitung bei 110 K zeigt und vollständig supraleitend ist bei 102 K.

**Ansprüche**

1. Verfahren zur Herstellung einer supraleitenden oxidischen, mindestens eine Wismut-Cuprat-Verbindung enthaltenden Schicht auf einem Substrat, wobei eine homogene Lösung aus metallorganischen Verbindungen in Form von Carbonsäure-Verbindungen von Calcium, Strontium, Wismut und Kupfer in einem organischen Lösungsmittel auf dem Substrat abgeschieden wird, wonach die metallorganischen Verbindungen thermisch zersetzt werden und die Schicht anschließend bei einer Temperatur im Bereich von 700 bis 950 °C ausgeheizt wird,
dadurch gekennzeichnet,
daß Wismut in einer Menge im Bereich von 10 bis 40 Atom% durch Blei substituiert wird.

2. Verfahren nach Anspruch 1,
dadurch gekennzeichnet,
daß Wismut in einer Menge von 20 Atom% durch Blei substituiert wird.

3. Verfahren nach Anspruch 1 oder 2,
dadurch gekennzeichnet,
daß als organisches Lösungsmittel Kohlenwasserstoffe mit einem Siedepunkt im Bereich von 160 bis 190 °C eingesetzt werden.

4. Verfahren nach mindestens einem der Ansprüche 1 bis 3,
dadurch gekennzeichnet,
daß die metallorganischen Verbindungen bei einer Temperatur im Bereich von 300 bis 600 °C thermisch zersetzt werden.

5. Verfahren nach mindestens einem der Ansprüche 1 bis 4,
dadurch gekennzeichnet,
daß der Abscheidungsprozeß, der Zersetzungsprozeß und der Ausheizprozeß wiederholt werden, bis eine gewünschte Schichtdicke erreicht ist.

6. Verfahren nach mindestens einem der Ansprüche 1 bis 5,
dadurch gekennzeichnet,
daß die auf dem Substrat abgeschiedenen und anschließend thermisch zersetzten metallorganischen Verbindungen über eine Dauer von 1 bis 60 h ausgeheizt werden.

7. Verfahren nach mindestens einem der Ansprüche 1 bis 6,
dadurch gekennzeichnet,
daß die auf dem Substrat abgeschiedenen und anschließend thermisch zersetzten metallorganischen Verbindungen bei einer Temperatur im Bereich von 850 bis 878 °C ausgeheizt werden.

PHD 88-158